# EUROPEAN PATENT APPLICATION

(11) **EP 2 760 261 A1**
(43) Date of publication of application: **30.07.2014**
(21) Application number: 13000413.8
(22) Date of filing: 28.01.2013
(51) Int. Cl.: H05K 5/02

(54) **Electronic device holder**

(71) Applicant: Chang, Lerng-Horng, Neihu Dist Taipei City 11493 (TW)
(72) Inventor: Chang, Lerng-Horng, Neihu Dist Taipei City 11493 (TW)
(74) Representative: Zeitler - Volpert - Kandlbinder

(57) **Abstract**

An electronic device holder comprising holders (10), each of which has: a first baseplate (11) comprising a plurality of baseplate pilot holes (111, 112); at least a first lateral plate (12) located at a lateral edge of the first baseplate (11) and comprising pilot holes (121, 122); at least a second lateral plate (13) comprising pilot holes (131) and located at said lateral edge of the first baseplate (11) at which there are still the first lateral plates (12), and being parallel but opposite to the first lateral plates (12); further, the first and second lateral plate (12,13) are perpendicular to the first baseplate (11). As such, the present invention allows the electronic device (20), which will be installed in a rack (30) or be connected and stacked on a second electronic device (20A), to be easily assembled and stacked with no printed circuit boards inside any electronic device (20, 20A) affected, and facilitates flexible, efficient and safe installation.

## Description

### BACKGROUND OF THE INVENTION

### FIELD OF THE INVENTION

The present invention relates to a holder, particularly an electronic device holder for electronic devices fixed in a rack or on a specific mounting surface and flexibly installed, stacked and positioned.

### DESCRIPTION OF THE RELATED ART

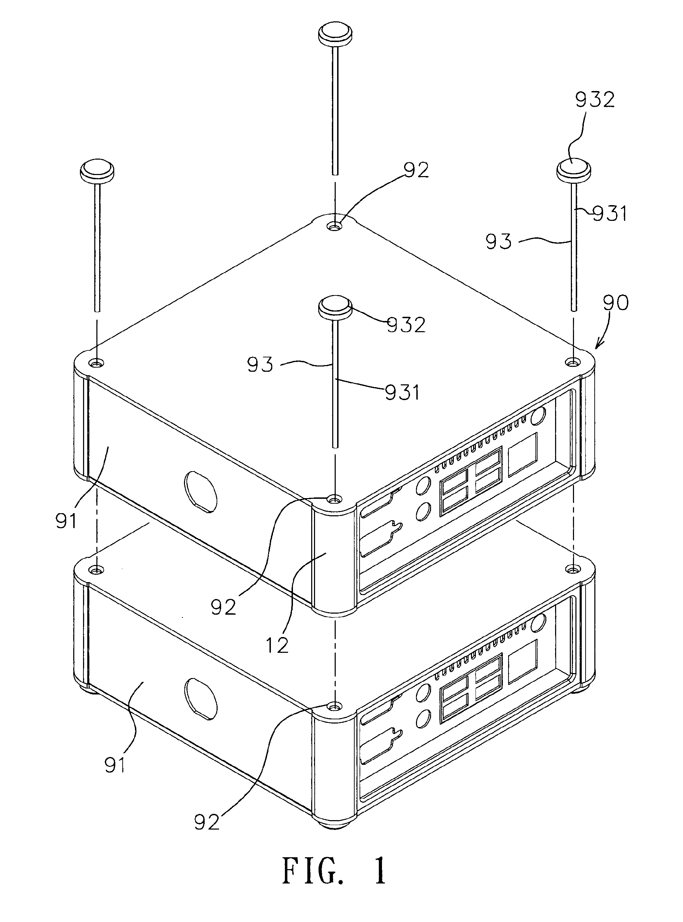

In general, those prevailing electronic devices to be electrically connected are regularly stacked in a rack for saving more space. As shown in FIG. 1, a combo-rack electronic device assembly unit 90 is described with two vertically arranged electronic devices 91, each of which comprises four pilot holes 92 located at its four corners and penetrated by four locating rods 93. During assembly, the locating rods 93 are inserted into the pilot holes 92 on the two vertically arranged electronic devices 91 in order to develop the two stackable electronic devices 91 and stably penetrate and lock the locating rods 93 into a rack (not shown in FIG. 1).

However, the above combo-rack electronic device assembly unit 90 based on the prior art to sustain electronic devices still has drawbacks, for example, the penetrable pilot holes 92 drilled at four corners of each electronic device 91 and inserted by the locating rods 93 in the combo-rack electronic device assembly unit 90 make more inner space of the electronic devices 91 occupied or the electronic devices 91 bulky due to space prepared for penetrations of the locating rods 93 and are unfavorable to prevailing electronic devices emphasizing compact design; furthermore, the combo-rack electronic device assembly unit 90 features the electronic devices 91 securely installed in a rack by themselves rather than any other supports, that is, the electronic devices 91 stacked in a rack on the spot, is not ideal design and deserves to be further considered or corrected because the design complicates future assembly/disassembly of electronic devices or jeopardize electronic devices. Against this background, it has become a critical issue to correct and get over drawbacks in assembly and positioning of the prior combo-rack electronic device assembly unit by persons skilled in the industry.

Accordingly, the inventor having considered imperfect structural design and other drawbacks of the prior art for a combo-rack electronic device assembly unit and attempted to optimize an electronic device holder with features such as convenient installation, flexibility, less inner space of an electronic device occupied, and specific mounting surface has studied and developed the present invention of an electronic device holder for promoting development of the industry.

### SUMMARY OF THE INVENTION

The object of the present invention is to provide an electronic device holder by which electronic devices to be installed in a rack can be assembled and stacked and realize flexible, efficient and safe installation in the rack.

The further object of the present invention is to provide an electronic device holder by which some electronic devices such as media player can be easily installed and fixed on a specific mounting surface in order to actively promote a service range and economic multi-functional efficiency.

To reach the above purposes, the present invention is based on technical measures comprising holders, each of which is assembled onto an electronic device and comprises: a first baseplate on which a plurality of baseplate pilot holes are prepared; at least a first lateral plate vertically erecting at a lateral edge of the first baseplate and comprising at least a pilot hole; at least a second lateral plate comprising at least a pilot hole and vertically erecting at the same lateral edge of the first baseplate at which there are still the first lateral plates, and the first and second lateral plates being in parallel but in opposite direction.

For technical features and effects in terms of the present disclosure completely understood and recognized, the preferred embodiments and accompanying drawings are thoroughly described hereinafter.

### BRIEF DESCRIPTION OF THE DRAWINGS

FIG. 1 is a schematic view illustrating a combo-rack electronic device assembly unit based on the prior art.
FIG. 2 is a schematic perspective view of the present invention.
FIG. 2a is a further schematic perspective view of the present invention from another view of angle.
FIG. 3 is a schematic exploded view of the present invention to be assembled.
FIG. 4 is a schematic view of the present invention in the first embodiment.
FIG. 5 is a schematic view of the present invention in the second embodiment.
FIG. 6 is a first schematic view of the present invention in the third embodiment.
FIG. 7 is a second schematic view of the present invention in the third embodiment.

### DETAILED DESCRIPTION OF THE PREFERRED EMBODIMENTS

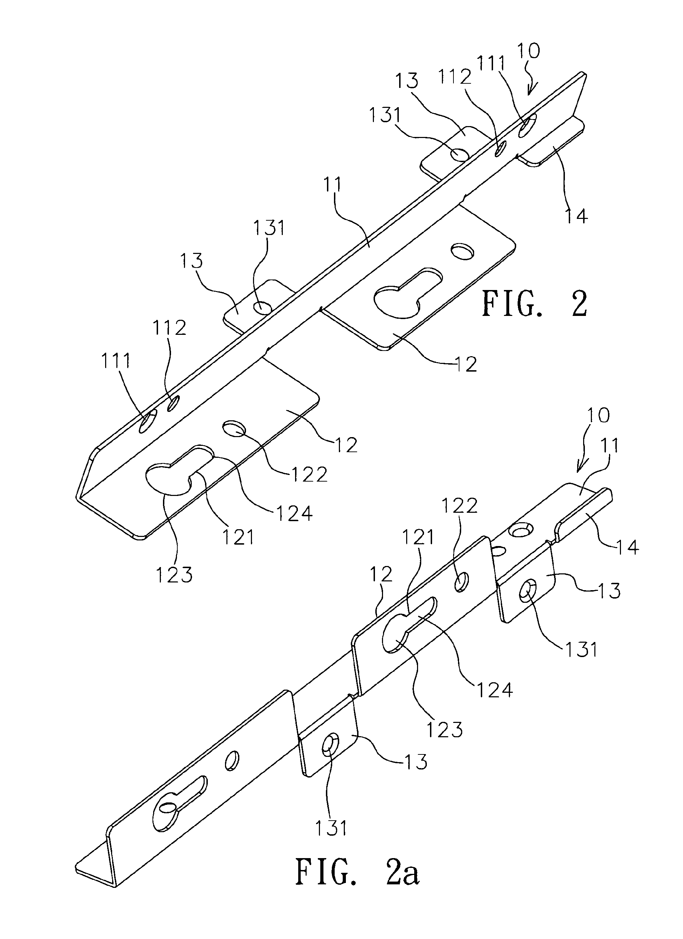

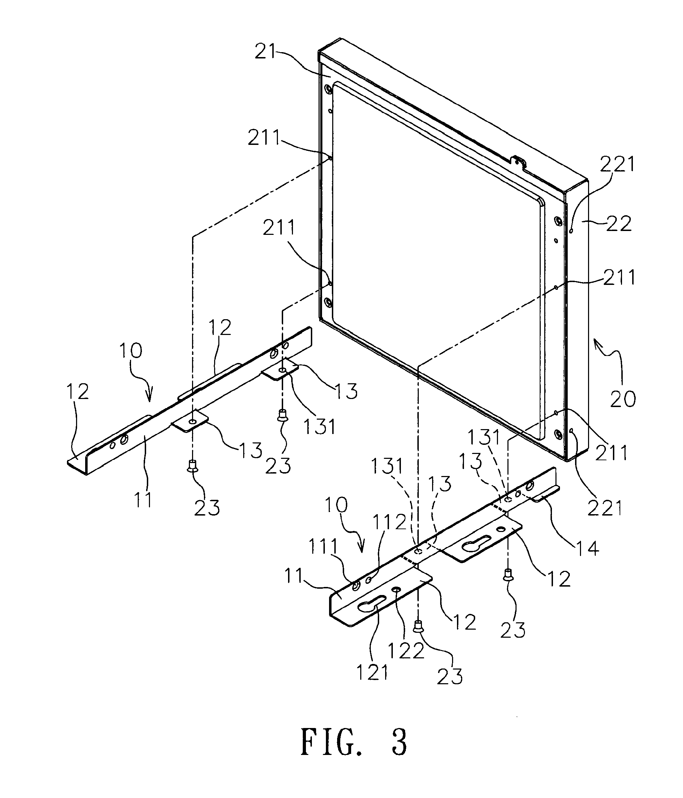

Referring to FIGS. 2, 2a and 3 which illustrate the present invention of an electronic device holder comprises holders 10: each of the holders 10 has a first baseplate 11 comprising a plurality of first lateral plates 12 and a plurality of second lateral plates 13 located at two opposite directions of a lateral edge of the first baseplate 11. That is, the same lateral edge of the first baseplate 11 is punched to two opposite directions to integrally form the first lateral plates 12 and the second lateral plates 13 respectively. As such that the first baseplate 11 is perpendicular to the first lateral plates 12 and the second lateral plates 13, and both of which are parallel and complementary to each other with respect to the first baseplate 11. The same lateral edge of the first baseplate 11 further comprises a third lateral plate 14 which is located at the same direction as the first lateral plates 12, and is smaller than the first lateral plates 12.

The first baseplate 11 comprises a plurality of baseplate pilot holes 111, 112 distributed with variable sizes; the first lateral plate 12 is designed to have a plurality of pilot holes 121, 122 in which the pilot hole 121 is formed by combining a larger round hole 123 with a slotted hole 124; the second lateral plate 13 is designed to have at least a pilot hole 131; the first lateral plates 12 and the third lateral plate 14 in a preferred embodiment are located at two different ends of the first baseplate 11 respectively.

As shown in FIG. 3, the holders 10 are used to join and position an electronic device 20 which comprising : (a) a reverse side 21 on which there are a plurality of bottom mounting holes 211 and (b) two junction sides 22 on which there are a plurality of lateral mounting holes 221 on each of the junction side 22; and the bottom mounting holes 211 and the lateral mounting holes 221 are distributed with variable sizes at different locations. During assembly, the second lateral plates 13 of the holders 10 resist the reverse side 21 of the electronic device 20 in order to combine the holders 10 and the electronic device 20 with screws 23 penetrating the pilot holes 131 and the bottom mounting holes 211. As such, the first baseplates 11 of the holders 10 resist the junction sides 22 of the electronic device 20.

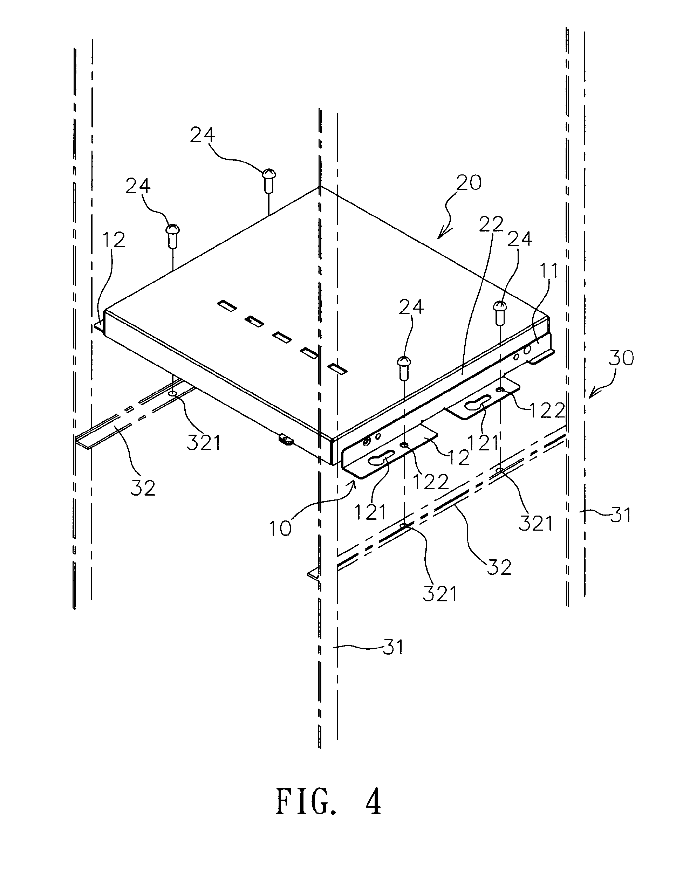

Referring to FIG. 4 which illustrates the present invention of an electronic device holder in a first embodiment: the electronic device 20 is installed in a rack 30 which is a frame body consisting of a plurality of longitudinal members 31 and a plurality of cross members 32, wherein each of the cross members 32 has a plurality of frame holes 321. During assembly, after the holders 10 are integrated with the electronic device 20, the first lateral plates 12 of the holders 10 are positioned over the cross members 32 in order to securely combine and position the electronic device 20 and the cross members 32 (of the rack 30) with screws 24 penetrating the pilot holes 122 on the first lateral plates 12 and the frame holes 321 on the cross members 32.

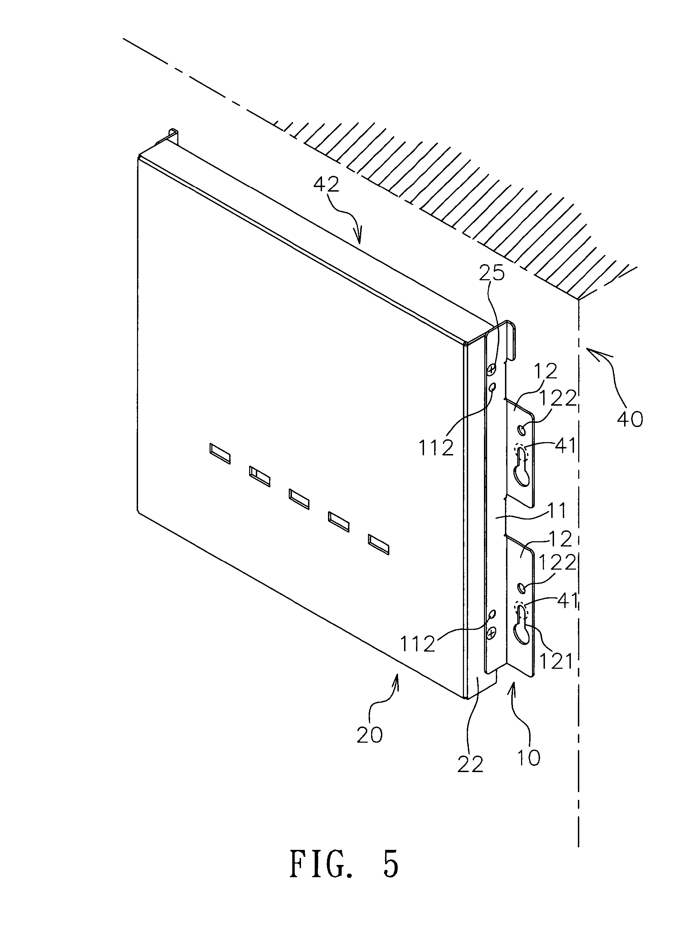

Referring to FIG. 5 which illustrates the present invention of an electronic device holder in a second embodiment based on the structure in the first embodiment. In the second embodiment, the electronic device 20 is fixed on a wall surface 40, that is, the electronic device 20 is hung on pegs 41 at the wall surface 40 through the pilot holes 121 of the first lateral plates 12 when the first lateral plates 12 of the holders 10 contact the wall surface 40, preferably both the electronic device 20 and the wall surface 40 develop a clearance 42 in between, and the first baseplates 11 are integrated with the electronic device 20 with screws 25 penetrating the baseplate pilot holes 111 of the first baseplates 11 and the lateral mounting holes 221 of the electronic device 20. Certainly, as an alternative means, the first lateral plates 12 can be fixed on the wall surface 40 with screws (not shown in the figure) penetrating the pilot holes 122. Furthermore, the electronic device 20 can be provided with a screen (not shown in the figure) in the front to be used as a multimedia device at the wall surface 40.

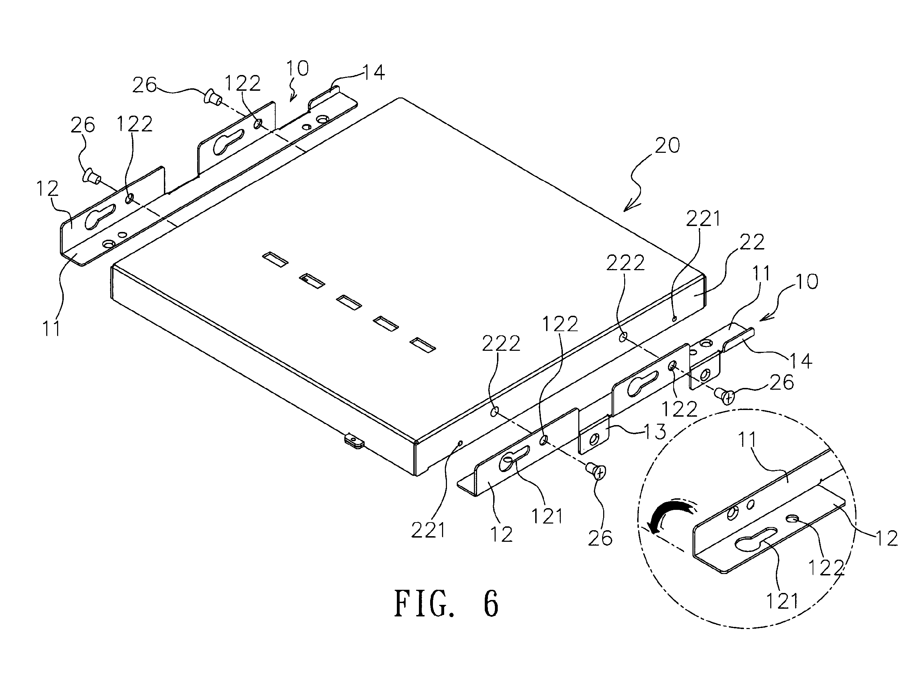

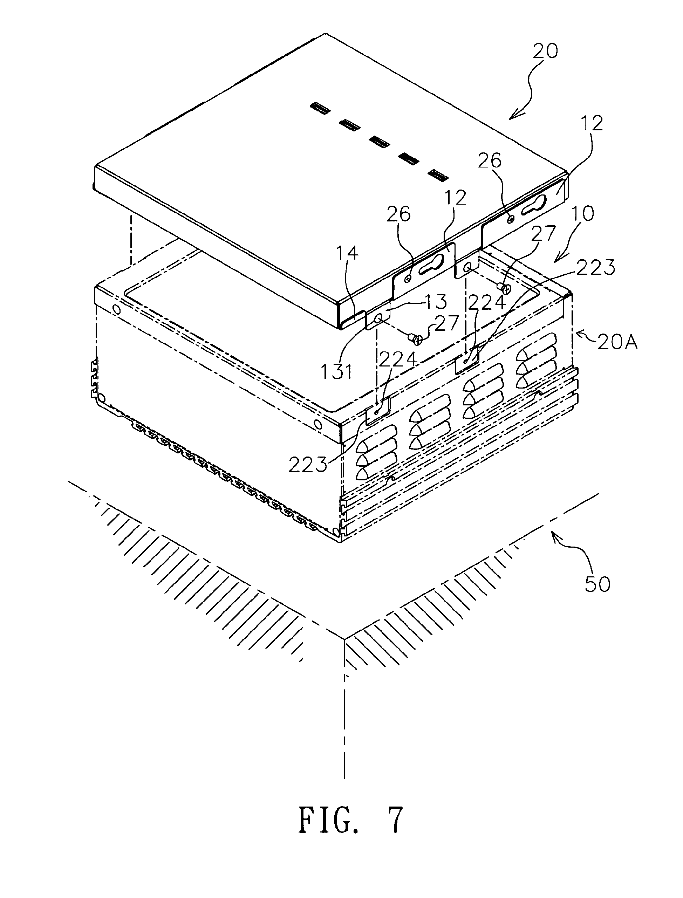

Referring to FIGS. 6 and 7 which illustrate the present invention of an electronic device holder in a third embodiment describing electronic devices stacked. In the third embodiment, the holders 10 are assembled into the electronic device 20 with the first baseplates 11 and the first lateral plates 12 fixed on the reverse side 21 (see FIG. 3) and the junction sides 22 respectively; and screws 26 penetrating the pilot holes 122 on the first lateral plates 12 and corresponding lateral mounting holes 222 on the junction sides of the electronic device 20 (see FIG. 6), and then the electronic device 20 is stacked on a second electronic device 20A underneath which is installed on a supporting surface 50 (see FIG. 7); in other words, the first baseplates 11 of the holders 10 are inserted into and held between the electronic device 20 at a top position and the second electronic device 20A at a lower position, and the second electronic device 20A is designed to have corresponding caulking groove surfaces 223 for lateral assembly, each of which has a lateral pilot hole 224, so that both the electronic device 20 and the second electronic device 20A are securely connected and stacked through the holders 10 with screws 27 penetrating the pilot holes 131 on the second lateral plates 13 and the lateral pilot holes 224 on the second electronic device 20A.

It can be seen from above descriptions that the present invention of an electronic device holder allows electronic devices, which will be installed in a rack, to be easily assembled and stacked with no printed circuit boards inside any electronic device influenced by pilot holes, and facilitates flexible, efficient and safe installation of all electronic devices in a rack. Moreover, the present invention is of service to an electronic device fixed on a specific mounting surface for display of multimedia and actively promotes a service range and economic multi-functional efficiency.

Therefore, the present invention significantly meets patentability and is applied for the patent. However, the above descriptions present preferred embodiments only which do not limit the scope of the present invention; any equivalent change or improvement based on shapes, structures, features and spirit mentioned in the present invention should be incorporated in claims of the present invention.

## Claims

1. An electronic device holder comprising holders (10), each of which is assembled into an electronic device (20) and comprises:
A first baseplate (11) on which a plurality of baseplate pilot holes (111, 112) are prepared;
At least a first lateral plate (12) punched at a lateral edge of said first baseplate (11), being perpendicular to said first baseplate(11), and further comprising at least a pilot hole (121 or 122);
At least a second lateral plate (13) punched at said lateral edge of said first baseplate (11), being in parallel but in opposite direction with respect to said first lateral plate (12), and said second lateral plate (13) is perpendicular to said first baseplate (12), and further comprising at least a pilot hole (131).

2. The electronic device holder according to claim 1, **characterized in that** said first lateral plates (12) and said second lateral plates (13) are located at opposite sides of said first baseplate (11) and complementary to each other.

3. The electronic device holder according to claim 1, **characterized in that** said first baseplate (11) is designed to connect a third lateral plate (14) located at said lateral edge, at which there are still said first lateral plates (12) and extending in line with said first lateral plates (11), wherein said third lateral plate (14) is smaller than said first lateral plates (12).

4. The electronic device holder according to claim 1, **characterized in that** said baseplate pilot holes (111, 112) are distributed with different sizes.

5. The electronic device holder according to claim 1, **characterized in that** said pilot hole (121) on said first lateral plate (12) is combined with a round hole (123) and a slotted hole(121).

6. The electronic device holder according to claim 3, **characterized in that** said first lateral plate (12) and said third lateral plate (14) are located at two different ends of said first baseplate (11) respectively.

7. The electronic device holder according to claim 1, **characterized in that** said holders (10) along with said electronic device (20) are assembled into a rack(30) which is a frame body with a plurality of longitudinal members (31) and a plurality of cross members (32), each of which has a plurality of frame holes (321), and said first lateral plates (12) of said holders (10) are positioned over said cross members (32) with screws (24) penetrating said pilot holes (122) on said first lateral plates (12) and said frame holes (321) on said cross members (32).

8. The electronic device holder according to claim 5, **characterized in that** said holders (10) assembled into said electronic device (20) are installed on a wall surface (40) and hung on pegs (41) at said wall surface (40) by means of said pilot holes (121) on said first lateral plates (12), and said electronic device (20) and said wall surface (40) develop a clearance (42) in between.

9. The electronic device holder according to claim 1, **characterized in that** said holders (10) assembled into said electronic device (20) are installed and fixed on a wall surface (40) with screws (24) penetrating said pilot holes (122) on said first baseplates (11).

10. The electronic device holder according to claim 8, **characterized in that** said electronic device (20) is provided with a front screen to display multimedia.

11. The electronic device holder according to claim 1, **characterized in that** said holders (10) are assembled into said electronic device (20) with said first baseplates (11) fixed on a reverse side (21) and said first lateral plates (12) fixed on two junction sides (22) of said electronic device (20) respectively; and said second lateral plates (13) are fixed to a second electronic device (20A) which is stacked underneath said electronic device (20).

12. The electronic device holder according to claim 11, **characterized in that** on both junction sides of said second electronic device (20A) are disposed at least a caulking groove surface (223) corresponding to said second lateral plates (13) of said holders (10), and said caulking groove surface (223) having a lateral pilot hole (224); as such that both said electronic device 20 and said electronic device (20A) are securely connected and stacked through said holders (10) with screws (27) penetrating said pilot holes (131) on said second lateral plates (13) and said lateral pilot holes (224) on said electronic device (20A).
